(19) Europäisches Patentamt
European Patent Office
Office européen des brevets

(11) EP 1 857 825 B1

## (12) EUROPÄISCHE PATENTSCHRIFT

(45) Veröffentlichungstag und Bekanntmachung des Hinweises auf die Patenterteilung:
**10.07.2019 Patentblatt 2019/28**

(51) Int Cl.:
*G01R 27/18* [(2006.01)]

(21) Anmeldenummer: **07008171.6**

(22) Anmeldetag: **21.04.2007**

(54) **Messanordnung**

Measuring apparatus

Dispositif de mesure

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **16.05.2006 DE 102006022686**

(43) Veröffentlichungstag der Anmeldung:
**21.11.2007 Patentblatt 2007/47**

(73) Patentinhaber: **SMA Solar Technology AG
34266 Niestetal (DE)**

(72) Erfinder: **Müller, Burkard
34123-Kassel (DE)**

(56) Entgegenhaltungen:
**EP-A- 0 833 423       EP-A- 1 265 076
EP-A- 1 437 600       WO-A-96/05516
WO-A-2004/093284   DE-A1- 1 513 510
GB-A- 1 504 181**

EP 1 857 825 B1

**Beschreibung**

Die Erfindung betrifft eine Messanordnung mit einem Erdungspunkt zur Ermittlung des Isolationswiderstandes ($R_{iso}$) einer unter Spannung stehenden elektrischen Vorrichtung oder einer Anlage mit einer Betriebsspannung ($U_B$) mit einem Pluspol und einem Minuspol, wobei zwei Schalter ($S_1$ und $S_2$) oder ein entsprechender Umschalter vorhanden sind, die jeweils einen Strompfad zwischen einem der beiden Pole und dem Erdungspunkt herstellen, um bei Auftreten ein oder mehrerer Isolationsfehler mit beliebigem Potentialbezug den sich insgesamt ergebenden Isolationswiderstand ($R_{iso}$) zu ermitteln.

In elektrischen Anlagen können durch Feuchtigkeit, Verschmutzung, Kurzschlüsse oder andere Ursachen Fehler in der Isolation zwischen einem spannungsführenden Anlagenteil und Erde auftreten.

Bei geerdeten elektrischen Anlagen entsteht durch einen solchen Fehler unmittelbar ein Stromfluss in der Erdverbindung, so dass die Isolation z.B. durch eine Strommessung in der Erdverbindung überwacht und der Fehler sofort behoben werden kann. Schwieriger ist die Überwachung in ungeerdeten Geräten oder Anlagen, wo die Erdverbindung erst durch die Verbindung mit einer anderen, geerdeten Anlage (z.B. Zuschaltung auf das öffentliche Netz) oder durch Berührung eines Anlagenteils entsteht. Ein Isolationsfehler führt hier zunächst zu keinem Stromfluss. Wird die Anlage jedoch nun (an einem anderem Punkt) berührt, ist durch die doppelte Verbindung nach Erde ein Stromkreis geschlossen, in dem gefährliche Körperströme fließen können. Ein ähnliches Problem tritt auf, wenn die Anlage mit einer geerdeten Vorrichtung verbunden wird: Hier fließt ein Strom über beide Vorrichtungen und kann diese beschädigen. Um solche Fehler zu vermeiden, ist es sinnvoll, regelmäßig den Isolationswiderstand der Anlage zu messen, damit bei Unterschreiten eines Grenzwertes geeignete Maßnahmen ergriffen werden können.

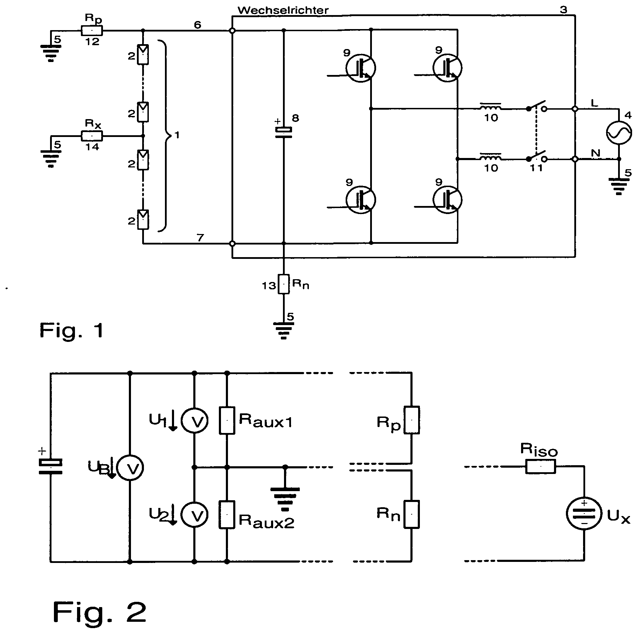

Zur Darstellung des Isolationszustands eines spannungsführenden Gerätes bzw. einer spannungsführenden Anlage sind verschiedene Ersatzschaltbilder (ESB) gebräuchlich. Bei Anlagen, die ausschließlich aus Plus- und Minuspol bestehen, wie z.B. Stromschienensystemen, ist es sinnvoll, alle Erdschlüsse am Pluspol in einem Widerstand $R_p$ und alle Erdschlüsse am Minuspol in einem Widerstand $R_n$ zusammenzufassen (Fig. 2). Bei Vorrichtungen, in denen auch beliebige Zwischenpotentiale auftreten, wie z.B. einem PV-Generator, kann es dagegen sinnvoller sein, ein ESB aus dem Isolationswiderstand $R_{iso}$ und dem Potential $U_x$, auf dem ein Erdschluss auftritt, zu verwenden. Grundsätzlich sind beide ESB gleichwertig und können ineinander umgerechnet werden, so entspricht z.B. $R_{iso}$ der Parallelschaltung aus $R_n$ und $R_p$. Auch Fehlerfälle mit mehreren Erdschlüssen auf verschiedenen Potentialen können durch beide ESB erfasst werden. $R_{iso}$ entspricht dabei immer der Parallelschaltung aller Leckwiderstände, während $U_x$ bzw. das Verhältnis $R_n/R_p$ einen Anhaltspunkt für die Lage der Erdschlüsse gibt.

Der Isolationswiderstand ist unproblematisch zu messen, wenn nur ein Isolationsfehler $R_p$ zwischen Pluspol und Erde oder ein Isolationsfehler $R_n$ zwischen Minuspol und Erde auftritt. Hierzu muss nur die Erde (PE) jeweils über bekannte, hochohmige Widerstände $R_{aux1}$, $R_{aux2}$ mit den beiden Polen verbunden werden und zwei der drei Spannungen

- Pluspol gegen Erde ($U_1$)
- Erde gegen Minuspol ($U_2$)
- Pluspol gegen Minuspol ($U_B$)

gemessen werden (Fig. 2). Eine der drei Spannungen ergibt sich aus den beiden anderen und muss daher nicht gemessen werden. Da $R_p$ bzw. $R_n$ zu einem der bekannten, hochohmigen Widerständen parallel liegt, kann mit Hilfe der Spannungsteilerregel der Wert der Parallelschaltung und damit auch der Wert von $R_n$ bzw. $R_p$ ermittelt werden.

Treten gleichzeitig Isolationsfehler $R_p$ und $R_n$ auf, funktioniert das beschriebene Verfahren nicht mehr, da damit jeweils nur ein Wert $R_n$ oder $R_p$ ermittelt werden kann. Auch ein Erdschluss, der auf einem anderen Potential als Plus- oder Minuspol entsteht, kann nicht mit einem Ersatzschaltbild aus nur einem Widerstand beschrieben werden.

In der EP 1 265 076 wird daher ein erweitertes Verfahren beschrieben, bei dem zunächst die obige Messung durchgeführt wird, und anschließend über ein Schaltelement ein bekannter Widerstand zwischen Erde und einen der beiden Pole geschaltet wird, wonach wiederum Spannungsmessungen durchgeführt werden. Nachteilig an dieser Anordnung ist die geringe Messgenauigkeit, falls ein niederohmiger Isolationsfehler parallel zum geschalteten Zweig bestimmt werden soll. Durch das Parallelschalten des bekannten, hochohmigen Widerstands ändern sich die Spannungsverhältnisse nur geringfügig, so dass eine im Verhältnis zum Messbereich der Spannungsmessung sehr kleine Spannungsänderung ausgewertet werden muss. Der relative Messfehler steigt dadurch stark an.

Ein niederohmiger Isolationsfehler kann besser ausgewertet werden, wenn z.B. bei einem Isolationsfehler von Plus nach Erde der bekannte, hochohmige Widerstand zum Minuspol geschaltet wird und umgekehrt. In der DE 35 13 849 ist dies so vorgesehen, allerdings wird die zusätzliche Messung mit einem geschlossenem Schalter erst dann durchgeführt, wenn bei der Messung mit geöffneten Schaltern bereits Grenzwerte überschritten werden. Erdschlüsse, die nicht direkt am Plus- oder Minuspol auftreten, sondern auf Potentialen dazwischen, werden mit dieser Methode nicht unbedingt gefunden. So würde z.B. ein Erdschluss in der Mitte eines Photovoltaik-Generators zu keiner Änderung der gemessenen Spannung bei geöffneten Schaltern führen, so dass erst gar keine Messung bei geschlossenem Schalter durchgeführt würde und damit der Erdschluss nicht erkannt werden könnte. In den Zeichnungen zur DE 35 13 849 sind Umschalter abgebildet, die eine offene Mittelstellung besitzen, d.h. die Funktion entspricht der von zwei einzelnen Schaltern, die nicht gleichzeitig geschlossen werden können. Das Verfahren ist beispielsweise zum Überwachen der Isolationswiderstände einer elektrischen Anlage mit einer erdfreien Stromversorgung einer Fernmelde- oder signaltechnischen Einrichtung bekannt. Hierbei sind Gestelle zum Aufnehmen von Baugruppen vorhanden, die geerdet sind.

In der EP 0 833 423 wird die gleiche elektrische Anordnung beschrieben wie in der DE 35 13 849, der Messablauf ist aber generell so definiert, dass ein Messzyklus eine Messung bei zwei geöffneten Schaltern und eine Messung mit einem geöffneten und einem geschlossenen Schalter umfasst. In der Schrift ist nicht angegeben, welcher der beiden Schalter geschlossen werden soll; sinnvoller Weise wird diese Entscheidung aber wie in der DE 35 13 849 getroffen. Setzt man ideale Messeinrichtungen voraus, könnte man mit diesem Verfahren beliebige Erdschlüsse exakt bestimmen. Dazu werden die in der Schrift angegebenen Berechnungsvorschriften

$$R_{L1} = R_S \left( \frac{v_1}{v_2} \cdot \frac{v_2{'}}{v_1{'}} - 1 \right)$$

$$R_{L2} = R_S \left( \frac{v_2{'}}{v_1{'}} - \frac{v_2}{v_1} \right)$$

verwendet. Nachteilig ist, dass zur Berechnung der Leckwiderstände $R_n$ ($R_{L1}$) und $R_p$ ($R_{L2}$) die Messung von jeweils zwei Momentanwerten zwei verschiedener Spannungen und die Kenntnis des genauen Wertes des zugeschalteten Widerstands nötig ist. Da alle Messgrößen in der Praxis mit einem Messfehler behaftet sind, gehen die Messfehler beider Spannungen in die berechneten Widerstandswerte ein.

Diese Anordnung wird beispielsweise bei einem DC-System für die Londoner Untergrundbahn eingesetzt.

Die Druckschrift EP 1 437 600 A1 offenbart eine Schaltung und ein Verfahren zur Überwachung der Isolationswiderstände zwischen der positiven Klemme einer Batterie und einer Fahrzeugmasse und zwischen der negativen Klemme der Batterie und der Fahrzeugmasse. Die Messanordnung ist hierbei prinzipiell die gleiche wie in der EP 0 833 423 mit einem Strompfad zwischen jeder der beiden Klemmen der Batterie und der Fahrzeugmasse über jeweils einen hochohmigen Widerstand und einen ersten bzw. zweiten Schalter. Zur Messung des Isolationswiderstandes zwischen der positiven Klemme und der Fahrzeugmasse wird der erste Schalter geschlossen, während der zweite Schalter geöffnet ist. In einer zweiten, anschließenden Messung wird dann der Isolationswiderstand zwischen der negativen Klemme und der Fahrzeugmasse gemessen, wozu der zweite Schalter geschlossen wird, während der erste Schalter geöffnet ist.

Aus der Druckschrift DE 1 513 510 ist eine Schaltungsanordnung zur Isolationsüberwachung von gleichspannungsgespeisten elektrischen Anlagen bekannt, bei der mit Hilfe eines Umschalters nacheinander ein Strompfad zwischen den beiden Polen der die elektrische Anlage speisenden Spannungsquelle und Erde über einen Vorwiderstand hergestellt wird und jeweils der Strom in dem Strompfad gemessen wird. Die Druckschrift DE 1 513 510 gibt Rechenvorschriften an, mit denen aus den gemessenen Strömen die jeweils als konzentriert angenommenen Isolationswiderstände zwischen der positiven Anschlussklemme der Spannungsquelle und Erde sowie zwischen der negativen Anschlussklemme der Spannungsquelle und Erde ermittelt werden können.

Der Erfindung liegt die Aufgabe zugrunde, eine Messanordnung zu schaffen, mit der eine genaue Messung des Isolationswiderstandes $R_{iso}$ möglich ist, auch wenn jeweils Leckwiderstände nach Plus und nach Minus, $R_p$ und $R_n$, gleichzeitig auftreten oder ein Leckwiderstand auf einem Zwischenpotential auftritt. Um den Einfluss möglicher Messfehler klein zu halten, sollen dabei möglichst wenige Messgrößen zur Berechnung von $R_{iso}$ herangezogen werden.

Die Aufgabe wird erfindungsgemäß durch die Merkmale der Ansprüche 1 und 9 gelöst. Der Messablauf ist gegenüber dem Verfahren aus EP 0 833 423 so geändert, dass ein Messzyklus sowohl eine Messung mit geöffnetem Schalter $S_1$ und geschlossenem Schalter $S_2$ als auch eine Messung mit geöffnetem Schalter $S_2$ und geschlossenem Schalter $S_1$ umfasst.

Durch die erfindungsgemäße Messanordnung ist es möglich, den Isolationswiderstand mit hoher Genauigkeit zu messen. Durch das erfindungsgemäße Schalten der Schalter ergeben sich sehr handliche Gleichungen, die von einer Recheneinheit leicht und schnell berechnet werden können.

Ein wichtiger Vorteil der Erfindung besteht darin, dass eine Messung mit hoher Genauigkeit auch dann möglich ist, wenn mehrere Leckwiderstände vorhanden sind. Die Messanordnung arbeitet also auch dann einwandfrei, wenn Leckwiderstände $R_n$ und $R_p$ gleichzeitig auftreten oder ein Isolationsfehler an einer Stelle auftritt, die nicht auf dem positiven oder dem negativen Pol liegt, beispielsweise in der Mitte eines Solargenerators. Mit einer einfachen Anordnung nach dem Stand der Technik, wie in Figur 2 beschrieben, wären die ermittelten Isolationswiderstände höher als tatsächlich, so dass der Benutzer sich fälschlicherweise in Sicherheit wiegen würde. Selbst mit den verbesserten Anordnungen nach EP 1 265 076, DE 35 13 849 und EP 0 833 423 ist nur eine schlechtere Messgenauigkeit möglich, so dass mit der erfindungsgemäßen, verbesserten Messung geringere Sicherheitsaufschläge erforderlich sind, was bedeutet, dass bei einem einzuhaltenden Grenzwert für $R_{iso}$ die Anlagenausfallhäufigkeit geringer ist. Damit ergibt sich eine höhere Verfügbarkeit der Anlage bei hohem Sicherheitsstandard für den Anlagenbetreiber.

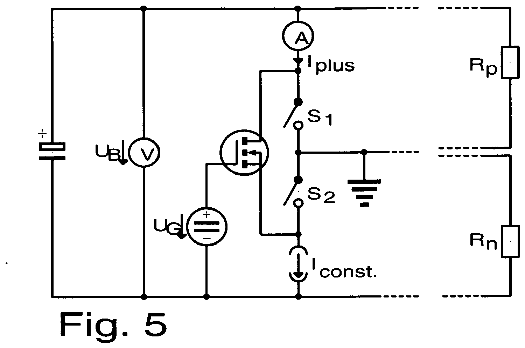

In der Ausgestaltung der Erfindung wird die aufwendige potentialfreie Strommessung an einen der beiden Pole der Anlage verlegt, so dass die Auswertung leichter durch einen Mikroprozessor mit entsprechendem Bezugspotential erfolgen kann (Fig. 5). Dazu wird ein Schalter $S_2$ nicht direkt an einen Pol angeschlossen, sondern über eine Stromquelle, die eine im Verhältnis zur Betriebs-spannung $U_B$ vernachlässigbare Versorgungsspannung benötigt. Diese wird durch einen entsprechend angesteuerten Transistor, z.B. einen bipolaren Transistor mit möglichst hoher Stromverstärkung oder einen Feldeffekttransistor, zur Verfügung gestellt. Der Kollektor- bzw. Drainanschluss des Transistors wird mit dem nicht mit PE verbundenen Anschluss des zweiten Schalters $S_1$ verbunden. Zwischen diesem Verbindungspunkt und dem zweiten Pol wird eine Strommesseinrichtung angeschlossen. Wenn $I_{plus}$ der Strom bei geschlossenem Schalter $S_1$ und geöffnetem Schalter $S_2$ und $I_{plus}'$ der Strom bei geschlossenem Schalter $S_2$ und geöffnetem Schalter $S_1$ ist, ergibt sich

$$R_n = \frac{U_B}{I_{plus} - I_{const}}$$

$$R_p = \frac{U_B}{-I_{plus}' + I_{const}}$$

$$R_{iso} = \frac{U_B}{I_{plus} - I_{plus}'}$$

Wiederum durch die Differenzmessung gehen sowohl Offsetfehler der Strommessung wie auch Streuungen der Stromquelle nicht in die Berechnung ein, so dass auch hier eine hohe Messgenauigkeit erzielt wird. Zur einfachen Auswertung der Messung durch einen Mikrocontroller kann der Strom $I_{plus}$ über einen Shunt geführt werden, der an einen A/D-Wandler im Mikrocontroller angeschlossen ist. Der Mikrocontroller kann dann nacheinander die Messwerte für $U_B$, $I_{plus}$ und $I_{plus}'$ aufnehmen und die Berechnung von $R_{iso}$ vornehmen.

Besonders vorteilhaft stellt sich die Messung des Isolationswiderstandes bei Photovoltaik-Anlagen zur elektrischen Energieerzeugung dar. Durch eine präzise Überwachung auf Erdschlüsse kann eine Gefährdung von Personen oder empfindlichen elektronischen Geräten rechtzeitig erkannt werden, selbst wenn mehrere Isolationsfehler auf unterschiedlichen Potentialen auftreten.

Besonders vorteilhaft ist der Einsatz der erfindungsgemäßen Messanordnung bei transformatorlosen Wechselrichtern. Für diese Wechselrichter sind niederohmige Erdschlüsse auch in der Generatormitte eine Gefahr, da hierdurch der Wechselrichterausgang praktisch kurzgeschlossen wird. Die resultierenden hohen Ströme können zur Beschädigung bzw. Zerstörung der Leistungshalbleiter führen. Schäden an den Halbleitern des Wechselrichters können zwar durch andere Sicherheitsmaßnahmen wie Stromüberwachung vermieden werden, die Fehlerursache würde aber nicht angezeigt. Die Suche nach dem Fehler wäre dann langwierig und kostspielig, wenn keine Messung des Isolationswiderstandes erfolgt. Die erfindungsgemäße Isolationswiderstandsmessung kann rechtzeitig den Fehler anzeigen sowie das Zuschalten des Wechselrichters auf das öffentliche Netz verhindern. Durch die Erfindung können insbesondere transformatorlose Wechselrichter zuverlässig geschützt und Ausfallzeiten wirksam verkürzt werden.

Weitere vorteilhafte Ausgestaltungen der Erfindung sind den Unteransprüchen zu entnehmen.

Anhand der Zeichnungen wird die Erfindung nachstehend beispielhaft näher erläutert.

Fig. 1    zeigt den Aufbau einer netzgekoppelten Photovoltaik-Anlage mit Isolationsfehlern;

Fig. 2    zeigt das Ersatzschaltbild einer Anlage mit einer einfachen Messanordnung zur Bestimmung eines einzelnen Leckwiderstands $R_n$ oder $R_p$;

Fig. 3    zeigt eine Darstellung einer Messanordnung in einem ersten Beispiel mit Spannungsmessung;

Fig. 4    zeigt eine Darstellung einer Messanordnung in einem zweiten Beispiel mit einer Strommessung;

Fig. 5    zeigt eine Darstellung der Erfindung mit einer indirekten Strommessung mit Hilfe einer Konstantstromquelle und eines Transistors;

Fig. 1 zeigt eine netzgekoppelte Photovoltaik-Anlage als Beispiel für eine auf Isolationsfehler zu überwachende Anlage. Bestandteile der Anlage sind ein Photovoltaik-Generator 1 aus mehreren Solarzellen 2 und ein Wechselrichter 3, der an ein Wechselspannungsnetz 4, das mit der Erde 5 verbunden ist, angeschlossen ist. Die Anlage besitzt einen Pluspol 6 und einen Minuspol 7. Der Wechselrichter 3 besteht beispielsweise aus einem Pufferkondensator 8, Leistungshalbleitern 9, Speicherdrosseln 10 und einer Vorrichtung zur Netzzuschaltung 11.

Weiterhin sind als Beispiele für mögliche Isolationsfehler im Photovoltaik-Generator oder Wechselrichter ein Leckwiderstand $R_p$ 12 zwischen Pluspol 6 und Erde 5, ein Leckwiderstand $R_n$ 13 zwischen Minuspol 7 und Erde 5 sowie ein Leckwiderstand $R_x$ 14 von einem beliebigen Potential nach Erde 5 eingezeichnet. Es gilt:

$$R_{iso} = \cfrac{1}{\cfrac{1}{R_p} + \cfrac{1}{R_n} + \cfrac{1}{R_x}}$$

Das Vorhandensein der Isolationsfehler führt bei Berührung von Anlagenteilen zu Körperströmen und damit zur Gefährdung von Personen. Beim Zuschalten des Netzes ergibt sich ein Stromfluss durch die gesamte Anlage, was zur Beschädigung bzw. Zerstörung der Bauteile der Anlage führen kann.

Ein einzelner Isolationsfehler am Plus- oder Minuspol, d.h. ein einzelner Leckwiderstand $R_p$ oder $R_n$, kann mit einer einfachen Anordnung nach Fig. 2 bestimmt werden. Dazu sind Hilfswiderstände $R_{aux1}$ und $R_{aux2}$ erforderlich. Da $R_p$ bzw. $R_n$ zu einem der bekannten, hochohmigen Widerstände $R_{aux1}$ und $R_{aux2}$ parallel liegt, kann mit Hilfe der Spannungsteilerregel der Wert der Parallelschaltung und damit auch der Wert von $R_n$ bzw. $R_p$ ermittelt werden.

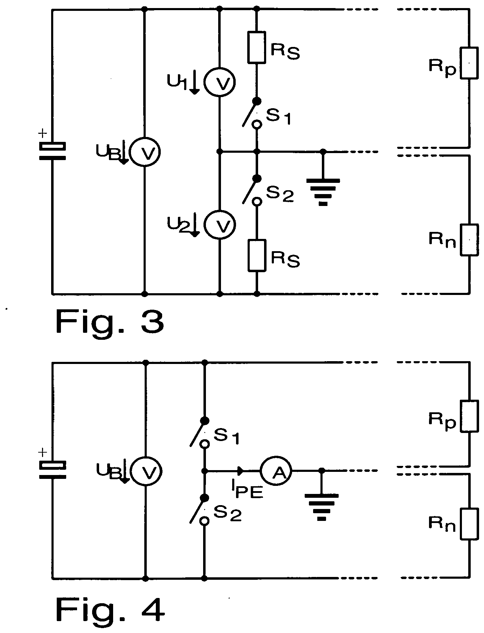

Fig. 3 zeigt ein erstes Beispiel einer Messanordnung. Der gezeigte Aufbau wird auch in der EP 0 833 423 verwendet. Fig. 4 zeigt ein zweites Beispiel einer Messanordnung. Hierbei ist eine Strommesseinrichtung zwischen Erde 5 und dem Verbindungspunkt der beiden Schalter vorgesehen, um den Strom zur Berechnung des Isolationswiderstandes zu messen. Der Messzyklus bleibt gegenüber der Vorschrift zu Fig. 3 unverändert.

Fig. 5 zeigt die Ausführungsform der Erfindung. Bei dieser erfolgt eine indirekte Strommessung. Die Schaltung nutzt eine zusätzliche Konstantstromquelle, die den konstanten Strom $I_{const}$ liefert. Der Schalter $S_2$ wird nicht direkt auf den Pluspol geschaltet, sondern über die Stromquelle. Zusätzlich ist ein MOSFET mit geeigneter Ansteuerung $U_G$ den beiden Schaltern $S_1$ und $S_2$ parallel geschaltet. Von Vorteil ist hierbei, dass statt des Stromes $I_{PE}$ mit Bezug zur Erde 5 ein Strom $I_{plus}$ mit Bezug zum Pluspol der Anlage gemessen wird. Der Strom kann so, z.B. über einen Shunt, gut mit einem Mikroprozessor gemessen werden, dessen Bezugspotential auf diesem Pol liegt. Wie auch bei der Ausgestaltung nach Fig. 4 ist bei dieser Lösung eine genaue Messung ohne hochpräzise Widerstände möglich.

Mit dem vorgestellten Verfahren und den beschriebenen Messanordnungen kann also der Isolationswiderstand $R_{iso}$ eines unter Spannung stehenden elektrischen Gerätes oder einer Anlage mit einem Pluspol 6 und einem Minuspol 7 bestimmt werden. Beide Schalter $S_1$, $S_2$ stellen beim Schließen jeweils einen Strompfad zwischen Erde und einem der beiden Pole 6,7 her. Mit dieser Anordnung können Isolationsfehler an beiden Polen 6,7, auf beliebigen Potentialen dazwischen sowie beliebige Kombinationen dieser Fehlerfälle erfasst werden. Der sich insgesamt ergebende Isolationswiderstand kann in einfacher Weise sehr genau ermittelt werden.

Bezugszeichenliste

| 1 | Photovoltaik-Generator |
|---|---|
| 2 | Solarzellen |
| 3 | Wechselrichter |
| 4 | Wechselspannungsnetz |
| 5 | Erde (PE) |
| 6 | Pluspol |
| 7 | Minuspol |
| 8 | Pufferkondensator |
| 9 | Leistungshalbleiter |
| 10 | Speicherdrossel |
| 11 | Vorrichtung zur Netzzuschaltung |
| 12 | Stromquelle |
| 13 | Transistor |

| $R_{iso}$ | Isolationswiderstand |
|---|---|
| $R_p$ | Leckwiderstand am Pluspol |
| $R_n$ | Leckwiderstand am Minuspol |
| $R_x$ | Leckwiderstand auf Zwischenpotential |
| $U_B$ | Betriebsspannung der Anlage vom Plus- zum Minuspol |
| $U_x$ | Ersatzspannung zur Beschreibung der Lage von Isolationsfehlern |
| $U_1$ | Spannung zwischen Pluspol und Erde |
| $U_2$ | Spannung zwischen Erde und Minuspol |
| $R_{aux1}$ | erster Hilfswiderstand in einfacher Messschaltung |
| $R_{aux2}$ | zweiter Hilfswiderstand in einfacher Messschaltung |
| $S_1$ | erster Schalter |
| $S_2$ | zweiter Schalter |

**Patentansprüche**

1. Messanordnung mit einem Erdungspunkt (5) zur Ermittlung des Isolationswiderstandes Riso einer unter Spannung stehenden elektrischen Vorrichtung oder einer Anlage mit einer Betriebsspannung $U_B$ mit einem Pluspol (6) und einem Minuspol (7), wobei zwei Schalter ($S_1$, $S_2$) oder ein entsprechender Umschalter vorhanden sind, die jeweils einen Strompfad zwischen einem der beiden Pole und dem Erdungspunkt (5) herstellen, um bei Auftreten eines oder mehrerer Isolationsfehler mit beliebigem Potentialbezug den sich insgesamt ergebenden Isolationswiderstand Riso zu ermitteln, wobei die Messanordnung dazu eingerichtet ist, zur Ermittlung des Isolationswiderstandes zwei aufeinanderfolgende Messungen durchzuführen, wobei der Erdungspunkt (5) nacheinander mit dem Plus- (6) und dem Minuspol (7) der Betriebsspannung verbunden wird, wobei eine Strommesseinrichtung zwischen dem nicht mit dem Erdungspunkt verbundenen Anschluss eines der beiden Schalter ($S_1$, $S_2$) oder des

entsprechenden Umschalters und einem der beiden Pole eingefügt ist, wobei der nicht mit dem Erdungspunkt (5) verbundene Anschluss des anderen Schalters oder des entsprechenden Umschalters über eine Konstantstromquelle mit dem anderen der beiden Pole verbunden ist, wobei ein Transistor so parallel zu den beiden Schaltern oder dem entsprechenden Umschalter angeordnet ist, dass sein Emitter- bzw. Source-Anschluss an die Konstantstromquelle angeschlossen ist, während sein Kollektor- bzw. Drainanschluss an einem Verbindungspunkt an die Strommesseinrichtung derart angeschlossen ist, dass die Strommesseinrichtung zwischen dem einen Pol und diesem Verbindungspunkt angeschlossen ist, wobei der Transistor derart angesteuert ist, dass durch ihn für die Konstantstromquelle eine im Verhältnis zur Betriebsspannung $U_B$ vernachlässigbare Versorgungsspannung zur Verfügung gestellt wird, und wobei die bei den beiden Messungen mit der Strommesseinrichtung gemessenen Ströme zur Berechnung des Isolationswiderstandes Riso verwendet werden.

2. Messanordnung nach Anspruch 1,
   **dadurch gekennzeichnet,**
   **dass** die Messanordnung dazu eingerichtet ist, den Isolationswiderstand $R_{iso}$ aus $Ri_{so}=U_B/(I_{plus}-I_{plus}')$ zu berechnen, wobei $I_{plus}$ der mit der Strommesseinrichtung gemessene Strom bei geschlossenem Schalter $S_1$ und geöffnetem Schalter $S_2$ ist und $I_{plus}'$ der mit der Strommesseinrichtung gemessene Strom bei geschlossenem Schalter $S_2$ und geöffnetem Schalter $S_1$ ist.

3. Messanordnung nach einem der vorhergehenden Ansprüche,
   **dadurch gekennzeichnet,**
   **dass** die Messanordnung dazu eingerichtet ist, den Strom $I_{plus}$ über einen Shunt zu messen.

4. Messanordnung nach einem der vorhergehenden Ansprüche,
   **dadurch gekennzeichnet,**
   **dass** ein Mikrocontroller oder Mikroprozessor zur Berechnung des Isolationswiderstandes Riso vorhanden ist.

5. Messanordnung nach einem der vorhergehenden Ansprüche,
   **dadurch gekennzeichnet,**
   **dass** die Schalter ($S_1$, $S_2$) oder der entsprechende Umschalter Relaisschalter oder Halbleiterschalter sind.

6. Verwendung einer Messanordnung nach einem der Ansprüche 1 bis 5 zur Messung des Isolationswiderstandes bei Photovoltaik-Anlagen zur elektrischen Energieerzeugung.

7. Verwendung einer Messanordnung nach einem der Ansprüche 1 bis 5 zur Messung des Isolationswiderstandes bei Wechselrichtern, insbesondere Solar-Wechselrichtern.

8. Verwendung einer Messanordnung nach einem der Ansprüche 1 bis 5 zur Messung des Isolationswiderstandes bei transformatorlosen Wechselrichtern.

9. Verfahren zur Ermittlung des Isolationswiderstandes $R_{iso}$ einer unter Spannung stehenden elektrischen Vorrichtung oder einer Anlage mit einer Betriebsspannung $U_B$ mit einem Pluspol (6) und einem Minuspol (7) mit einer Messanordnung mit einem Erdungspunkt (5), zwei Schaltern ($S_1$, $S_2$) oder einem entsprechenden Umschalter, die jeweils einen Strompfad zwischen einem der beiden Pole und dem Erdungspunkt (5) herstellen, um bei Auftreten eines oder mehrerer Isolationsfehler mit beliebigem Potentialbezug den sich insgesamt ergebenden Isolationswiderstand $R_{iso}$ zu ermitteln, einer Strommesseinrichtung zwischen dem nicht mit dem Erdungspunkt verbundenen Anschluss eines der beiden Schalter ($S_1$, $S_2$) oder des entsprechenden Umschalters und einem der beiden Pole, einer Verbindung des nicht mit dem Erdungspunkt (5) verbundenen Anschlusses des anderen Schalters oder des entsprechenden Umschalters mit dem anderen der beiden Pole über eine Konstantstromquelle, und einem Transistor, der so parallel zu den beiden Schaltern oder dem entsprechenden Umschalter angeordnet ist, dass sein Emitter- bzw. Source-Anschluss an die Konstantstromquelle angeschlossen ist, während sein Kollektor- bzw. Drainanschluss an einem Verbindungspunkt an die Strommesseinrichtung derart angeschlossen ist, dass die Strommesseinrichtung zwischen dem einen Pol und diesem Verbindungspunkt angeschlossen ist und der derart angesteuert ist, dass durch ihn für die Konstantstromquelle eine im Verhältnis zur Betriebsspannung $U_B$ vernachlässigbare Versorgungsspannung zur Verfügung gestellt wird, wobei zur Ermittlung des Isolationswiderstandes zwei aufeinanderfolgende Messungen durchgeführt werden, wobei der Erdungspunkt (5) nacheinander mit dem Plus- (6) und dem Minuspol (7) der Betriebsspannung verbunden wird, und die bei den beiden Messungen mit der Strommesseinrichtung gemessenen Ströme zur Berechnung des Isolationswiderstandes Riso verwendet werden.

10. Verfahren nach Anspruch 9, wobei der Isolationswiderstand Riso aus $R_{iso}=U_B/(I_{plus}-I_{plus}')$ berechnet wird, wobei $I_{plus}$ der mit der Strommesseinrichtung gemessene Strom bei geschlossenem Schalter $S_1$ und geöffnetem Schalter $S_2$ ist und $I_{plus}'$ der mit der Strommesseinrichtung gemessene Strom bei geschlossenem Schalter $S_2$ und geöffnetem Schalter

$S_1$ ist.

11. Verfahren nach einem der Ansprüche 9 oder 10, wobei der Strom $I_{plus}$ über einen Shunt gemessen wird.

12. Verfahren nach einem der Ansprüche 9 bis 11, wobei die Berechnung des Isolationswiderstandes $R_{iso}$ durch einen Mikroprozessor erfolgt.

**Claims**

1. A measuring arrangement with a grounding point (5) for determining the insulation resistance $R_{iso}$ of an energized electrical device or an installation having an operating voltage $U_B$ with a positive pole (6) and a negative pole (7), wherein two switches ($S_1$, $S_2$) or a corresponding changeover switch are provided that each establish a current path between one of the two poles and the grounding point (5), in order to determine the overall resulting insulation resistance $R_{iso}$ in the event of one or more insulation faults with arbitrary potential reference occurring, the measuring arrangement being arranged to carry out two successive measurements in order to determine the insulation resistance, the grounding point (5) being connected successively to the positive pole (6) and the negative pole (7) of the operating voltage, wherein a current measuring device is inserted between the terminal of one of the two switches ($S_1$, $S_2$) or the corresponding changeover switch not connected to the grounding point and one of the two poles, the terminal of the other switch or the corresponding changeover switch not connected to the grounding point (5) being connected to the other of the two poles via a constant current source, wherein a transistor is arranged in parallel with the two switches or the corresponding changeover switch such that its emitter or source terminal, respectively, is connected to the constant current source while its collector or drain terminal, respectively, is connected to the current measuring device at a connection point in such a way that the current measuring device is connected between the one pole and this connection point, the transistor being driven in such a way that it provides a supply voltage for the constant current source that is negligible in relation to the operating voltage $U_B$, and the currents measured in the two measurements with the current measuring device being used to calculate the insulation resistance $R_{iso}$.

2. The measuring arrangement according to claim 1, **characterized in that** the measuring arrangement is arranged to calculate the insulation resistance Riso from $R_{iso}=U_B/(I_{plus}-I_{plus}')$, wherein $I_{plus}$ is the current measured with the current measuring device when the switch $S_1$ is closed and the switch $S_2$ is open, and $I_{plus}'$ is the current measured with the current measuring device when the switch $S_2$ is closed and the switch $S_1$ is open.

3. The measuring arrangement according to any one of the preceding claims, **characterized in that** the measuring arrangement is arranged to measure the current $I_{plus}$ via a shunt.

4. The measuring arrangement according to any one of the preceding claims, **characterized in that** a microcontroller or microprocessor is provided for calculating the insulation resistance $R_{iso}$.

5. The measuring arrangement according to any one of the preceding claims, **characterized in that** the switches ($S_1$, $S_2$) or the corresponding changeover switch are relay switches or semiconductor switches.

6. A use of a measuring arrangement according to any one of claims 1 to 5 for measuring the insulation resistance in photovoltaic systems for electrical power generation.

7. A use of a measuring arrangement according to any one of claims 1 to 5 for measuring the insulation resistance of inverters, in particular solar inverters.

8. A use of a measuring arrangement according to any one of claims 1 to 5 for measuring the insulation resistance of transformerless inverters.

9. A method for determining the insulation resistance $R_{iso}$ of an energized electrical device or an installation having an operating voltage $U_B$ with a positive pole (6) and a negative pole (7) with a measuring arrangement having a grounding point (5), two switches ($S_1$, $S_2$) or a corresponding changeover switch that each establish a current path between one of the two poles and the grounding point (5), in order to determine the overall resulting insulation resistance $R_{iso}$ in the event of one or more insulation faults with arbitrary potential reference occurring, a current measuring device between the terminal of one of the two switches ($S_1$, $S_2$) or the corresponding changeover switch not connected to the grounding point and one of the two poles, a connection of the terminal of the other switch or the corresponding changeover switch not connected to the grounding point (5) to the other of the two poles via a constant current source, and a transistor that is arranged in parallel with the two switches or the corresponding changeover switch such that its emitter or source terminal, respectively, is connected to the constant current source, while its collector or drain terminal, respectively, is connected to the current measuring device at a connection point in such a way that the current measuring device is connected between the one pole and this connection point and that is driven in such a way that it provides a supply voltage for the constant current source that is negligible in relation to the operating voltage $U_B$, wherein two successive measurements are carried out to determine the insulation resistance, wherein the grounding point (5) is connected successively to the positive pole (6) and the negative pole (7) of the operating voltage, and the currents measured in the two measurements with the current measuring device are used to calculate the insulation resistance $R_{iso}$.

10. The method according to claim 9, wherein the insulation resistance $R_{iso}$ is calculated from $R_{iso}=U_B/(I_{plus}-I_{plus}')$, wherein $I_{plus}$ is the current measured with the current measuring device when switch $S_1$ is closed and switch $S_2$ is open and $I_{plus}'$ is the current measured with the current measuring device when switch $S_2$ is closed and switch $S_1$ is open.

11. The method according to any one of claims 9 or 10, wherein the current $I_{plus}$ is measured via a shunt.

12. The method according to any one of claims 9 to 11, wherein the insulation resistance $R_{iso}$ is calculated by a microprocessor.

**Revendications**

1. Dispositif de mesure comportant un point de mise à la terre (5) pour déterminer la résistance d'isolement $R_{iso}$ d'un appareil électrique sous tension ou d'une installation ayant une tension de service $U_B$ avec un pôle positif (6) et un pôle négatif (7), deux commutateurs ($S_1$, $S_2$) ou un sélecteur correspondant établissant chacun un chemin de courant entre un des deux pôles et le point de mise à la terre (5) étant prévus, pour déterminer la résistance d'isolement totale résultante $R_{iso}$ en cas d'un ou plusieurs défauts d'isolement avec référence de potentiel quelconque, le dispositif de mesure étant adapté pour effectuer deux mesures successives afin de déterminer la résistance d'isolement, le point de mise à la terre (5) étant relié successivement au pôle positif (6) et au pôle négatif (7) de la tension de service, un dispositif de mesure de courant étant inséré entre la borne de l'un des deux commutateurs ($S_1$, $S_2$) ou du sélecteur correspondant non relié au point de mise à la terre et l'un des deux pôles, la borne de l'autre commutateur ou du sélecteur correspondant non relié au point de mise à la terre (5) étant relié à l'autre des deux pôles via une source de courant constant, dans lequel un transistor est disposé en parallèle avec les deux commutateurs ou le sélecteur correspondant de manière à connecter sa borne émetteur ou bien sa borne source avec la source de courant constant, tandis que la borne collecteur ou bien la borne drain est relié au dispositif de mesure de courant par un point de raccordement de telle sorte que le dispositif de mesure de courant soit relié entre l'un des pôles et ce point de raccordement, le transistor étant commandé de telle sorte qu'il fournisse une tension d'alimentation pour la source de courant constant négligeable par rapport à la tension de service $U_B$, et les courants mesurés dans les deux mesures avec le dispositif de mesure de courant étant utilisés pour calculer la résistance d'isolement $R_{iso}$.

2. Dispositif de mesure selon la revendication 1, **caractérisé en ce que** le dispositif de mesure est adapté pour calculer la résistance d'isolement $R_{iso}$ à partir de $R_{iso}=U_B/(I_{plus}-I_{plus}')$, dans lequel $I_{plus}$ est le courant mesuré avec le dispositif de mesure de courant lorsque le commutateur $S_1$ est fermé et le commutateur $S_2$ est ouvert, et $I_{plus}'$ est le courant mesuré avec le dispositif de mesure de courant lorsque le commutateur $S_2$ est fermé et le commutateur $S_1$ est ouvert.

3. Dispositif de mesure selon l'une quelconque des revendications précédentes, **caractérisé en ce que** le dispositif de mesure est adapté pour mesurer le courant $I_{plus}$ via un shunt.

4. Dispositif de mesure selon l'une quelconque des revendications précédentes, **caractérisé en ce que** un microcontrôleur ou microprocesseur est prévu pour calculer la résistance d'isolement $R_{iso}$.

5. Dispositif de mesure selon l'une quelconque des revendications précédentes, **caractérisé en ce que** les commutateurs ($S_1$, $S_2$) ou le sélecteur correspondant sont des commutateurs relais ou des commutateurs semi-conducteurs.

6. Utilisation d'un dispositif de mesure selon l'une quelconque des revendications 1 à 5 pour mesurer la résistance d'isolement des systèmes photovoltaïques destinés à la production d'énergie électrique.

7. Utilisation d'un dispositif de mesure selon l'une quelconque des revendications 1 à 5 pour mesurer la résistance d'isolement des onduleurs, en particulier des onduleurs solaires.

8. Utilisation d'un dispositif de mesure selon l'une quelconque des revendications 1 à 5 pour mesurer la résistance d'isolement des onduleurs sans transformateur.

9. Procédé de détermination de la résistance d'isolement Riso d'un appareil électrique sous tension ou d'une installation ayant une tension de service $U_B$ avec un pôle positif (6) et un pôle négatif (7) avec un dispositif de mesure ayant un point de mise à la terre (5), deux commutateurs ($S_1$, $S_2$) ou un sélecteur correspondant, qui établissent chacun un chemin de courant entre un des deux pôles et le point de mise à la terre (5), pour déterminer la résistance d'isolement totale résultante $R_{iso}$ en cas d'un ou plusieurs défauts d'isolement avec référence de potentiel quelconque, un dispositif de mesure de courant entre la borne de l'un des deux commutateurs ($S_1$, $S_2$) ou du sélecteur correspondant non relié au point de mise à la terre et l'un des deux pôles, une connexion de la borne de l'autre commutateur ou du sélecteur correspondant non relié au point de mise à la terre (5) à l'autre des deux pôles via une source de courant constant et un transistor qui est disposé en parallèle avec les deux commutateurs ou le sélecteur correspondant de manière à connecter sa borne émetteur ou bien sa borne source avec la source de courant constant, tandis que la borne collecteur ou bien la borne drain est relié au dispositif de mesure de courant par un point de raccordement de telle sorte que le dispositif de mesure de courant soit relié entre l'un des pôles et ce point de raccordement et qui est commandé de telle sorte qu'il fournisse une tension d'alimentation pour la source de courant constante négligeable par rapport à la tension de service $U_B$, dans laquelle deux mesures successives sont effectuées pour déterminer la résistance d'isolement, le point de mise à la terre (5) étant relié successivement au pôle positif (6) et au pôle négatif (7) de la tension de service, et les courants mesurés dans les deux mesures avec le dispositif de mesure de courant sont utilisés pour calculer la résistance d'isolement $R_{iso}$.

10. Procédé selon la revendication 9, dans lequel la résistance d'isolement Riso est calculée à partir de $R_{iso}=U_B/(I_{plus}-I_{plus}')$, dans lequel $I_{plus}$ est le courant mesuré avec le dispositif de mesure de courant lorsque le commutateur $S_1$ est fermé et le commutateur $S_2$ est ouvert et $I_{plus}'$ est le courant mesuré avec le dispositif de mesure de courant lorsque le commutateur $S_2$ est fermé et le commutateur $S_1$ est ouvert.

11. Procédé selon l'une quelconque des revendications 9 ou 10, dans lequel le courant $I_{plus}$ est mesuré par un shunt.

12. Procédé selon l'une quelconque des revendications 9 à 11, dans lequel la résistance d'isolement $R_{iso}$ est calculée par un microprocesseur.

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1265076 A
- DE 3513849
- EP 0833423 A
- EP 1437600 A1
- DE 1513510